# FASCICULE DE BREVET EUROPEEN

(11) **EP 2 870 418 B1**
(45) Date de publication et mention de la délivrance du brevet: **29.08.2018**
(21) Numéro de dépôt: 13734114.5
(22) Date de dépôt: 05.07.2013
(51) Int. Cl.: F24S 80/00, H01L 31/042

(54) **DISPOSITIF DE RÉGULATION DU NIVEAU D'HUMIDITÉ DANS UN MODULE SOLAIRE A CONCENTRATION ET MODULE SOLAIRE COMPORTANT AU MOINS UN TEL DISPOSITIF**
VORRICHTUNG ZUR REGELUNG DES FEUCHTIGKEITSGEHALTES BEI EINEM KONZENTRIERENDEN SOLARMODUL UND SOLARMODUL MIT MINDESTENS EINER SOLCHEN VORRICHTUNG
DEVICE FOR REGULATING THE LEVEL OF MOISTURE IN A CONCENTRATING SOLAR MODULE AND SOLAR MODULE COMPRISING AT LEAST ONE SUCH DEVICE

(30) Priorité: 09.07.2012 FR 1256589
(43) Date de publication de la demande: 13.05.2015
(73) Titulaire: Commissariat à l'Énergie Atomique et aux Énergies Alternatives, 75015 Paris (FR)
(72) Inventeur: MARIOTTO, Mathieu, F-73290 La Motte-servolex (FR); DEGABRIEL, Florian, F-38600 Fontaine (FR); FAUCON, Thibaut, F-76480 Sainte Marguerite Sur Duclair (FR)
(74) Mandataire: Brevalex
(86) Numéro de dépôt international: PCT/EP2013/064299
(87) Numéro de publication internationale: WO 2014/009288

(56) Documents cités:
- EP-A1- 0 014 657
- EP-A1- 0 546 481
- DE-A1-102010 021 426
- FR-A1- 2 292 202
- FR-A1- 2 462 670
- FR-A1- 2 481 427
- US-A1- 2007 295 384
- US-A1- 2009 173 376

## Description

### DOMAINE TECHNIQUE ET ART ANTÉRIEUR

La présente invention se rapporte à un dispositif de régulation du niveau d'humidité dans un module solaire à concentration et à un module solaire comportant au moins un tel dispositif.

Les systèmes photovoltaïques à concentration connaissent un développement important du fait de l'augmentation significative des rendements des cellules triples jonctions qu'ils utilisent pour convertir l'énergie solaire concentrée en énergie électrique.

Un système photovoltaïque à concentration comporte des modules formés d'un caisson dont le fond supérieur est formé d'une ou plusieurs lentilles de Fresnel qui concentrent le flux solaire incident et le fond inférieur sert de support à une ou plusieurs cellules photovoltaïques. Le système comporte un châssis mobile appelé "tracker" sur lequel sont disposés un ou plusieurs modules; le châssis se déplace pour suivre la trajectoire du soleil de telle sorte que les rayons solaires soient toujours perpendiculaires aux lentilles.

Le rayonnement solaire direct est concentré par les lentilles et est transmis aux cellules photovoltaïques qui le convertissent en énergie électrique.

Le rayonnement des lentilles vers le ciel nocturne dégagé entraîne une diminution importante de la température des lentilles, qui, lorsqu'elle passe en dessous de la température de rosée de l'air qui est contenu dans le caisson, engendre l'apparition d'une première goutte d'eau liquide. Les lentilles présentent sur leur face intérieure une microstructure dentelée qui est le siège privilégiée du mécanisme de condensation liquide et de piégeage du condensat formé.

Il se forme donc une pellicule d'eau liquide ou solide sur la surface intérieure des lentilles, qui empêche la production d'électricité du fait du rayonnement direct nul; le rendement global du système est donc fortement dégradé. En outre, il en résulte un risque de corrosion des joints siliconés et des composants électriques par le condensat; la durée de vie et la fiabilité du système sont alors réduites de manière importante.

Par ailleurs, le facteur de concentration des systèmes de plus en plus grand, par exemple 1000 fois le soleil voire plus, implique une taille de caisson importante, ce qui engendre un volume d'air par m² de lentilles important, rendant encore plus difficile la gestion de l'apparition de la condensation.

Différentes solutions ont été proposées pour résoudre ce problème de condensation.

L'une de ces solutions est décrite dans le document US 2011/0154683. Ce document décrit un dispositif pour sécher l'intérieur d'un module solaire. Celui-ci est disposé à l'extérieur du caisson et est branché sur le caisson de sorte à permettre une circulation d'air entre l'environnement extérieur et l'intérieur du caisson. Le dispositif comporte un ventilateur qui aspire l'air de l'extérieur, cet air traverse un absorbeur d'humidité, l'air ainsi asséché est introduit dans le module solaire. Pour régénérer l'absorbeur, celui-ci est traversé par de l'air préalablement chauffé, cet air étant rejeté vers l'environnement extérieur.

Cette solution présente l'inconvénient de consommer de l'énergie électrique et de nécessiter une maintenance du ventilateur, des moyens de chauffage et des électrovannes.

Le document US2009/0173376 décrit un dispositif de gestion de l'humidité étant destiné à être fixé sur une paroi d'un caisson d'un module solaire.

### EXPOSÉ DE L'INVENTION

C'est par conséquent un but de la présente invention d'offrir un dispositif de régulation du niveau d'humidité dans un système photovoltaïque à concentration de conception simple et robuste offrant une durée de vie importante et dont le fonctionnement ne consomme pas d'énergie électrique.

Le but précédemment énoncé est atteint par un dispositif comportant un réceptacle destiné à être monté de manière étanche sur une paroi latérale du caisson du module solaire, le réceptacle comportant un matériau absorbeur d'humidité, le réceptacle comportant une ouverture montée en regard d'une ouverture pratiquée dans le caisson de sorte que l'intérieur du réceptacle soit en communication fluidique avec l'intérieur du caisson. Le dispositif comporte également un élément occultant disposé en regard de l'ouverture du réceptacle et à distance de celui-ci de sorte à ménager un passage ouvert entre l'élément occultant et l'ouverture du réceptacle dans lequel l'air contenu dans le caisson s'écoule par convection naturelle et traverse le canal du bas du canal vers le haut du caisson. L'élément occultant permet de protéger le matériau absorbant du rayonnement solaire concentré en cas de défocalisation du module solaire.

La convection naturelle résulte de l'apparition d'un gradient de température entre les lentilles qui voient leur température s'abaisser pendant la nuit du fait du rayonnement vers le ciel nocturne et la partie inférieure du caisson qui ne rayonne pas vers le ciel.

L'air entrant dans le passage est chargé de vapeur d'eau, la vapeur d'eau est alors absorbée par le matériau absorbant, et l'air ressortant est appauvri en vapeur d'eau.

Le dispositif est entièrement passif, il ne nécessite aucun apport d'énergie. Il ne dégrade donc pas le rendement énergétique global du système. Il est également de fait autonome et est très robuste. En outre, le matériau absorbant est protégé du flux concentré.

Il présente donc une durée de vie importante. Il ne demande aucune maintenance, qui est généralement complexe et coûteuse pour ce système dont l'implantation est souvent dans des zones isolées. Seul le matériau absorbant peut avoir à être remplacé, mais cela n'a lieu qu'après plusieurs années. Enfin, le coût de revient de ce dispositif est relativement faible.

Avantageusement le matériau est hygro-régulant, ainsi il permet de maintenir un niveau d'humidité donné au sein du caisson.

La présente invention a alors pour objet un dispositif de gestion de l'humidité contenu dans un caisson d'un module solaire comportant un boîtier dont une des parois est munie d'une fenêtre, au moins un matériau absorbant l'humidité disposé dans le boîtier, des moyens occultants disposés en regard de la fenêtre et à distance de celle-ci de sorte à ménager un espace pour l'écoulement d'air entre la fenêtre et les moyens occultants, lesdits moyens occultants étant aptes à protéger le matériau absorbant du rayonnement solaire concentré, ledit dispositif étant destiné à être fixé sur une paroi latérale du caisson du module solaire de sorte que ladite fenêtre soit en regard d'une ouverture réalisée dans ladite paroi latérale assurant avec ladite fenêtre une communication fluidique avec un volume intérieur d'un module solaire et les moyens occultants étant destinés à être situés à l'intérieur du module solaire.

Dans un exemple de réalisation, le boîtier comporte deux parois latérales de part et d'autre de la fenêtre de forme triangulaire ou trapézoïdale orientées de sorte que la profondeur du boîtier soit la plus grande dans sa partie supérieure.

Les moyens occultants comportent par exemple une plaque maintenue à distance de la fenêtre.

Avantageusement, le dispositif de gestion de l'humidité comporte des moyens de protection supplémentaires entre les moyens occultants et le boitier.

Les moyens de protection supplémentaires peuvent être sont situés au niveau d'un bord supérieur de la plaque et sont portés par la plaque et/ou le boîtier. Les moyens de protection supplémentaires sont avantageusement ajourés.

De préférence, les moyens de protection supplémentaires sont peints en noir.

Le matériau absorbant est avantageusement contenu dans un sachet souple. Le sachet est de préférence apte à s'adapter à une augmentation de volume du matériau absorbant.

Le sachet peut comporter une face imperméable à la vapeur d'eau et une surface perméable à la vapeur d'eau, ladite face perméable étant en regard de la fenêtre.

De manière avantageuse, le matériau absorbant est hygro-régulant. Il peut s'agit de CaCl2 sous forme de bille de 1 mm à 4 mm de diamètre.

Le boîtier peut comporter des moyens de retenue dudit matériau dans le boîtier de sorte à éviter qu'il sorte du boîtier. Les moyens de retenue peuvent être formés par des traverses situées au niveau de zones supérieure et inférieure de la fenêtre. De préférence, les traverses sont ajourées.

En variante, les moyens de retenue sont formés par des barreaux s'étendant au travers de la fenêtre.

De préférence, la surface extérieure du boîtier est peinte en noir.

La présente invention a également pour objet un module solaire pour système solaire à concentration comportant un caisson dont un fond supérieur est formé par un système optique et un fond inférieur opposé au fond supérieur par au moins une cellule photovoltaïque et une paroi latérale, et au moins un dispositif de gestion de l'humidité selon l'invention, monté dans la paroi latérale de manière étanche de sorte à obturer une ouverture pratiquée dans la paroi latérale, la fenêtre étant en regard de l'ouverture de sorte que les moyens occultants soient disposés à l'intérieur du caisson.

De préférence, le dispositif de gestion d'humidité est situé en position basse du module de telle sorte que les moyens occultants ne soient pas éclairés par le rayonnement solaire concentré lorsque le système solaire à concentration est correctement focalisé.

Le caisson peut comporter un évent obturé par une membrane respirante.

Dans un exemple de réalisation, les moyens occultants sont fixés sur la face intérieure de la paroi latérale et le boîtier est fixé sur la face extérieure de la paroi latérale du caisson.

La présente invention a également pour objet un système solaire à concentration comportant au moins un module solaire selon l'invention.

La présente invention a également pour objet un système solaire à concentration comportant plusieurs modules solaires selon l'invention.

Le système solaire est par exemple du type Fresnel.

### BRÈVE DESCRIPTION DES DESSINS

La présente invention sera mieux comprise à l'aide de la description qui va suivre et des dessins en annexe sur lesquels :
- la figure 1 est une vue en coupe transversale schématique d'un exemple de réalisation d'un module unitaire d'un système à concentration équipé d'un dispositif de gestion de l'humidité selon l'invention,
- la figure 2A est une vue en perspective d'un exemple de réalisation d'un dispositif de gestion de l'humidité selon l'invention représenté seul,
- la figure 2B représente la même vue que la figure2A, mais certaines pièces sont visibles en transparence,
- la figure 2C est une vue en perspective d'un autre exemple de forme pour le boîtier du dispositif de gestion,
- les figures 3A à 3D sont des vues de faces du dispositif de gestion de l'humidité selon l'invention suivant différentes variantes de réalisation, une partie appelée élément occultant ou bouclier ayant été retiré,
- les figures 4A à 4E sont des vues en coupe du dispositif de gestion de l'humidité selon l'invention montrant différentes variantes de réalisation du bouclier,
- la figure 5 est une vue en perspective d'un exemple de contenant pour le matériau absorbant l'humidité,
- les figures 6A à 6E sont des vues de différents éléments à différents stades de la réalisation d'un dispositif de gestion tel que celui de la figure 2A,
- la figure 7 est une vue en coupe longitudinale de deux modules munis chacun d'un dispositif de gestion de l'humidité selon l'invention,
- la figure 8 est une représentation graphique de la différence de température entre celle de l'air contenu dans le module et la température de rosée en fonction du temps en jour de cet air pour un module avec dispositif de gestion selon l'invention et un module sans dispositif de gestion.

Les termes «inférieur » et « supérieur » correspondent à l'orientation des dessins sur la feuille. Les termes « avant » et « arrière » sont considérés par rapport au dispositif de gestion d'humidité, son ouverture étant disposée en face avant. Ces termes ne sont en aucun cas limitatifs.

### EXPOSÉ DÉTAILLÉ DE MODES DE RÉALISATION PARTICULIERS

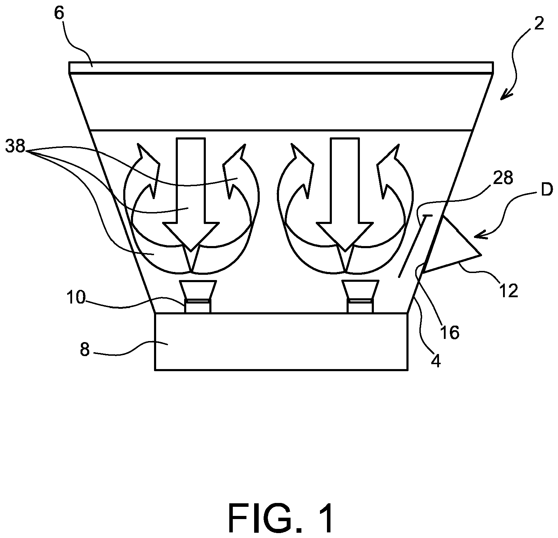

Sur la figure 1, on peut voir un module M unitaire d'un système à concentration à lentille de Fresnel comportant un caisson 2 composé d'une paroi latérale 4, d'un fond supérieur 6 et d'un fond inférieur 8.

Le fond supérieur 6 est formé par l'optique primaire comportant une ou plusieurs lentilles de Fresnel. Le fond inférieur 8 supporte des cellules photovoltaïques 10 par exemple du type triples jonctions. Chaque lentille focalise sur une cellule photovoltaïque 10. De préférence, le ou les cellules photovoltaïques 10 sont munies de dissipateurs de chaleur orientés vers l'extérieur du fond inférieur 8.

Le module M comporte également un dispositif D gestion de l'humidité à l'intérieur du caisson. Le dispositif D est monté sur la paroi latérale 4 du caisson 2.

Le dispositif de gestion de l'humidité D, désigné par la suite dispositif de gestion, comporte un boîtier 12 fixé sur la paroi latérale du caisson dont le volume intérieur et en communication fluidique avec le volume intérieur du caisson et contient un matériau absorbant l'humidité. Le matériau absorbant est de préférence disposé à l'intérieur d'un contenant souple, désigné « sachet » qui sera décrit en détail par la suite, ainsi que le matériau absorbant.

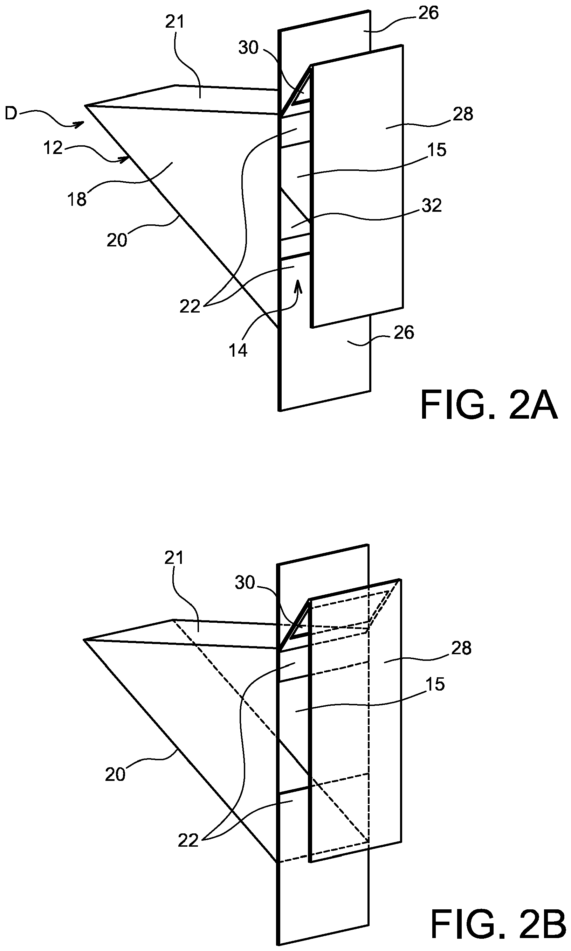

Sur les figures 2A et 2B, on peut voir un exemple de réalisation du dispositif de gestion D.

Le boîtier 12 présente une paroi avant 14 munie d'une fenêtre 15 destinée à être disposée en regard d'une ouverture 16 réalisée dans la paroi latérale du caisson 2.

Dans l'exemple représenté, le boîtier comporte deux parois latérales 18, une paroi arrière 20 inclinée par rapport au plan de la paroi avant 14 et une paroi supérieure 21 perpendiculaire au plan de l'ouverture 15. Dans cet exemple, les parois latérales 18 sont des triangles rectangles.

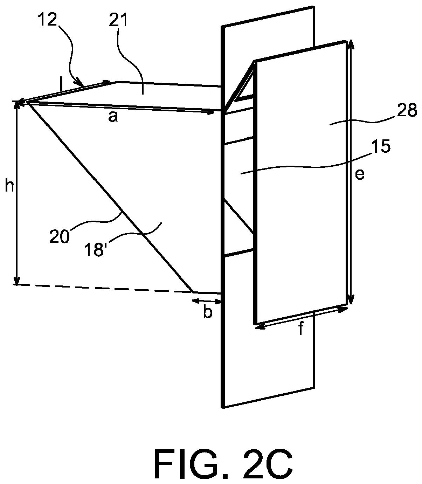

Sur la figure 2C, on peut voir une variante de réalisation du boîtier dans laquelle les parois latérales 18' sont des trapèzes, le boîtier comporte alors une paroi inférieure 23 de plus petite surface par rapport à celle à la paroi supérieure 21.

En variante encore, les parois latérales pourraient être des rectangles dont une partie des plus grands côtés définiraient deux côtés de l'ouverture. Dans cette variante, la paroi de fond est parallèle à l'ouverture.

Les bords inférieur et supérieur de la fenêtre 15 sont formés par des traverses inférieures et supérieures 22 de sorte que la fenêtre 15 présente une surface inférieure à la surface de la paroi avant 14.

Ces traverses 22 forment des moyens de retenue du sachet à l'intérieur du boîtier quelles que soient les positions du caisson auquel le boîtier est fixé, par exemple lors des phases de tracking où tout le module pivote et s'incline.

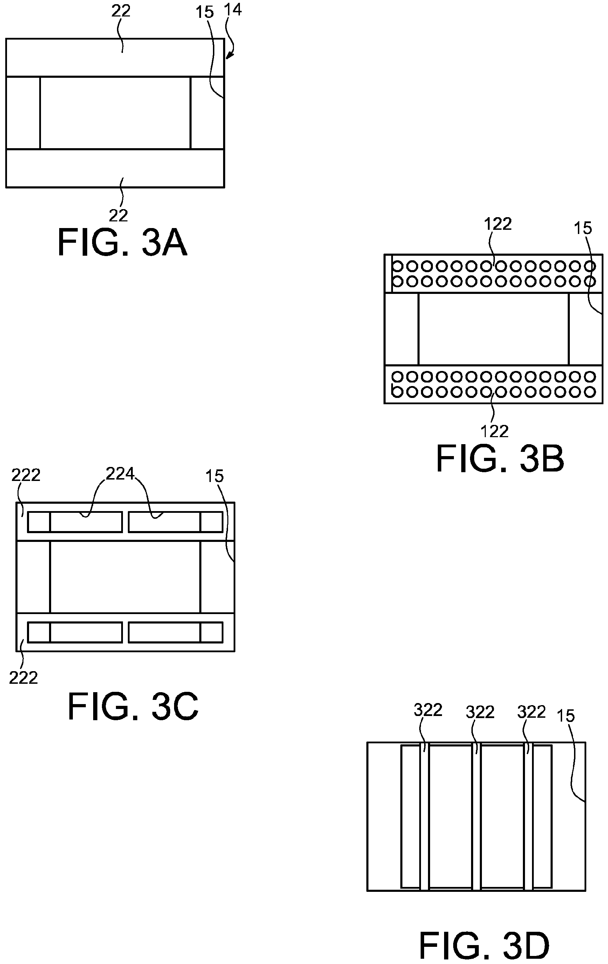

Sur les figures 3A à 3D, on peut voir différents exemples de forme des traverses 22.

Sur la figure 3A, les traverses sont pleines.

Sur la figure 3B et 3C, on peut voir des variantes de réalisation avantageuses dans lesquelles l'impact des traverses sur la surface de l'ouverture est réduit. Pour cela, sur la figure 3B, les traverses 122 sont perforées. Sur la figure 3C, les traverses 222 comportent chacune deux grands évidements 224 côte à côte dans la largeur de la fenêtre 15.

Un dispositif comporte par exemple une traverse de la figure 3A et une traverse de la figure 3B ou 3C ne sort pas du cadre de la présente invention

Sur la figure 3D, on peut voir un autre exemple de réalisation dans lequel les moyens de retenue sont formés non plus par des traverses horizontales mais par de barreaux verticaux 322 formant un râtelier. Dans cet exemple, l'impact sur la surface de l'ouverture est considérablement réduit.

Les barreaux ne sont pas nécessairement droits. En outre, ils peuvent être inclinés ou être horizontaux. Enfin on peut envisager de mettre en oeuvre un treillage ou grillage.

Le dispositif de la figure 2A comporte également des moyens de fixation 26 du boîtier sur la paroi latérale du caisson 2. Dans l'exemple représenté, la face avant 14 a une longueur supérieure à la hauteur de la paroi latérale, ainsi la paroi avant comporte une aile supérieure et une aile inférieure. En variante, le boîtier pourrait être intégré dans la paroi latérale 4 du caisson, les ailes supérieure et inférieure ne seraient plus requises.

Le dispositif comporte également un élément occultant 28 ou bouclier monté en regard de l'ouverture 15 à distance de celle-ci, à l'extérieur du boîtier de sorte que, lorsque le dispositif est monté sur le caisson le bouclier 28 se situe à l'intérieur du caisson. Le bouclier de protection 28 est destiné à occulter les rayons solaires concentrés pour le sachet, de sorte à éviter en cas de défocalisation la brûlure du sachet par les rayons concentrés, tout en permettant l'écoulement de l'air le long de l'ouverture 15.

De manière avantageuse et comme cela est représenté sur la figure 2B, le dispositif comporte des moyens 30 assurant une protection supplémentaire contre le dépointage sans gêner l'écoulement de l'air.

Sur la figure 2A, ces moyens sont formés par le bord supérieur du bouclier 28 qui est replié en direction de la fenêtre et est solidarisé au réceptacle au niveau de la traverse supérieure 22. Le bord replié 28.1 est muni de une ou plusieurs lumières de manière similaire aux traverses 222 de la figure 3C, afin de permettre un écoulement d'air à travers le bord plié.

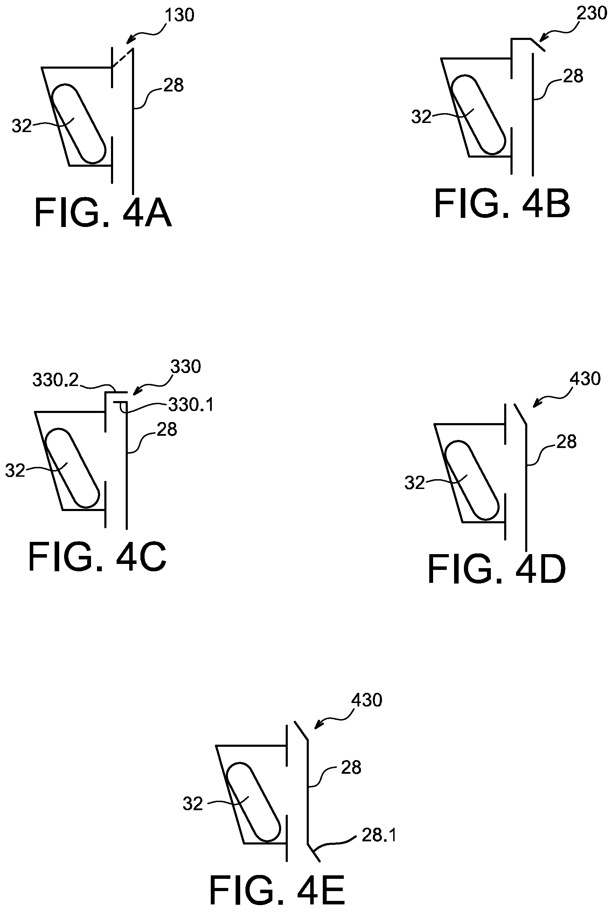

Sur les figures 4A à 4E, on peut voir différents exemples de réalisation des moyens de protection supplémentaires.

Sur la figure 4A, le bord replié 130 se distingue du bord replié de la figure 2A en ce qu'il est perforé.

Sur la figure 4B, les moyens de protection supplémentaires 230 sont formés par une tôle fixée sur la paroi avant 14 du boîtier et pliée de sorte à venir envelopper le bord supérieur du bouclier qui est formé par une plaque plane, l'air pouvant s'écouler entre la plaque et le bord supérieur du bouclier.

Sur la figure 4C, les moyens de protection supplémentaires 330 sont répartis sur le boîtier 12 et sur le bouclier 28. Pour cela, le bord supérieur 330.1 du bouclier 28 est replié à angle droit vers la paroi avant du boîtier 12 et le boîtier 12 comporte une tôle 330.2 qui forme un angle droit avec la paroi avant 14. Lors de l'assemblage, la tôle 330.2 est située au dessus du bord replié 330.1 du bouclier 28.

Sur les figures 4D et 4E, les moyens de protection supplémentaire 430 sont formés par le bord supérieur du bouclier 28 replié vers la paroi avant 14 du boîtier de sorte qu'il forme un angle compris entre 0°et 90° par rapport à sa position avant pliage.

Sur la figure 4E, le bord inférieur 28.1 est également replié mais du côté opposé à celui du bord supérieur par apport au plan du bouclier. Ce bord replié 28.1 facilite l'écoulement l'air.

Nous allons maintenant décrire le matériau absorbant.

Par exemple, celui-ci est un gel de silice, un tamis moléculaire en zéolite, de l'argile type Montmorillonite, de l'alumine activée, du sulfate de calcium

De manière très avantageuse, le matériau absorbant est un matériau absorbant et hygro-régulant, qui a pour effet de maintenir un certain niveau d'humidité.

De tels matériaux possèdent des capacités d'absorption et des réversibilités fonctionnelles variables. On entend par « réversibilité » la capacité du composé chimique à absorber et désorber de la vapeur d'eau dans des conditions de température données.

Par exemple, le taux d'humidité maximal pour éviter l'apparition de condensation a été évalué à environ 40%. Une hygro-régulation autour de cette valeur et des amplitudes de variation comprises entre 30% et 50% permet de maintenir un tel taux d'humidité. Par exemple, le chlorure de calcium possède un pouvoir hygro-régulant entre 40% et 50% d'humidité relative.

Le matériau se présente par exemple sous forme de poudre, de granulés, de billes ou gel.

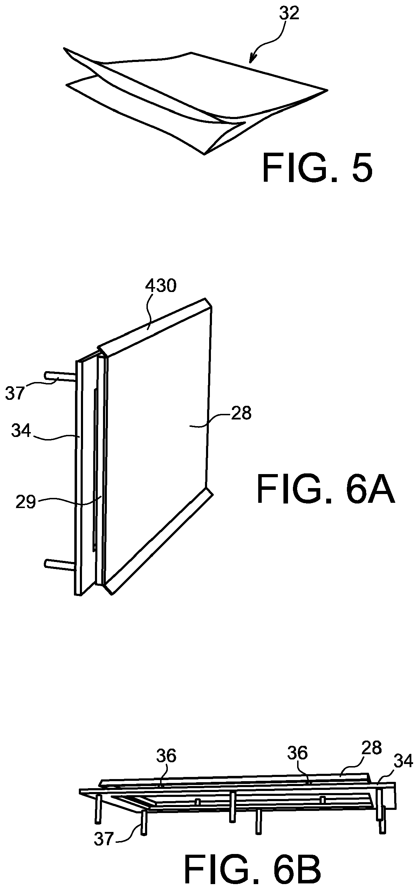

Le contenant est souple et est tel qu'il est apte à accommoder les variations de volume du matériau. Par exemple, le contenant est un sachet à soufflet 32 tel que représenté sur la figure 5.

En outre, le sachet comporte par exemple une face en un matériau étanche à l'eau, par exemple un film plastique et une face en un matériau perméable à la vapeur d'eau, type membrane respirante. La membrane perméable forme la surface active du sachet et est destinée à être orientée en face de la fenêtre 15.

Sur les figures 4A à 4E, on peut voir la disposition du sachet 32 dans le boîtier. Le sachet est disposé dans le boîtier de sorte que sa face perméable soit en face de l'ouverture 15.

Afin de favoriser la régénération du matériau absorbant et hygro-régulant, le boîtier est avantageusement recouvert sur sa surface extérieure d'un revêtement noir de sorte à approcher du comportement thermique du boîtier de celui d'un corps noir. Le boîtier absorbe alors une grande partie du rayonnement extérieur et chauffe le matériau absorbant qu'il contient et le soumet à une plage de température s'approchant de la plage de réversibilité du matériau, i.e. la plage de température dans laquelle la régénération de la capacité d'absorption du matériau a lieu, lorsque les conditions de gradient d'humidité entre l'air ambiant du caisson et l'air du sachet absorbant le permettent.

Ainsi l'état saturé du matériau est retardé, ce qui allonge le temps entre deux remplacements de matériau.

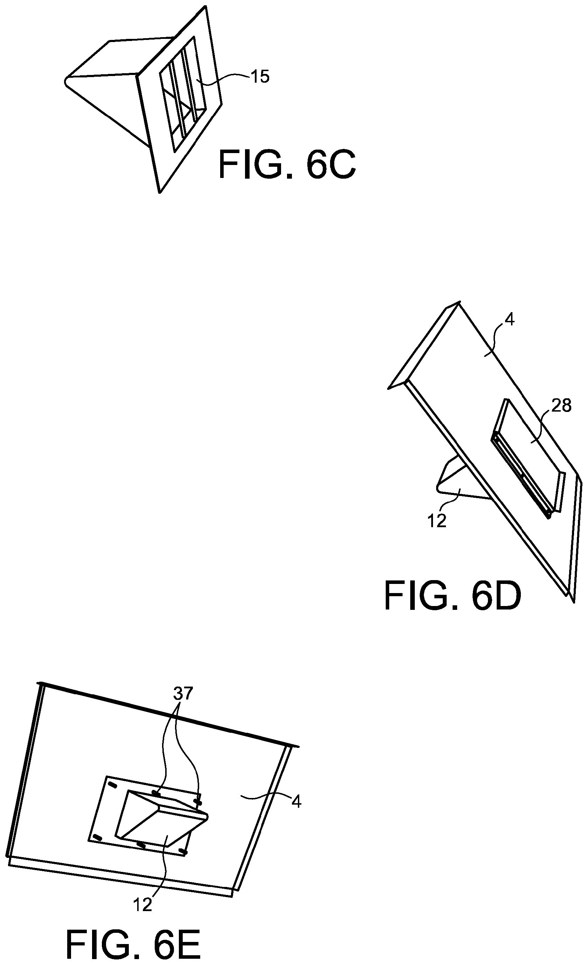

Un exemple de procédé de réalisation d'un dispositif de gestion va maintenant être décrit à l'aide des figures 6A à 6E.

Dans cet exemple, le bouclier et le boîtier sont montés séparément sur le caisson.

Le bouclier 28 est réalisé séparément puis fixé sur la face intérieure de la paroi latérale du caisson en regard de l'ouverture.

Le bouclier 28 est fixé à un support 34 en forme de cadre et à distance de celui-ci, par lequel il est fixé sur la paroi latérale 4 du caisson 2 autour de l'ouverture 16. Le bouclier 28 est fixé au cadre par des pions soudés 36. La hauteur des pions définit l'épaisseur de la nappe d'air destinée à circuler entre le bouclier et la fenêtre.

Avantageusement, le bouclier comporte également deux ailes 29 latérales inclinées vers le boîtier comme on peut les voir sur la figure 6A et formant une protection supplémentaire en cas de dépointage.

Comme décrit précédemment, le bouclier comporte deux ailes latérales 29 et des moyens supplémentaires de protection 430, et un bord inférieur replié pour faciliter l'écoulement de l'air.

Dans l'exemple représenté, le cadre 34 comporte également six tiges filetées 37 ou goujons fixés sur sa face opposée à celle fixée au bouclier. Le contour de l'ouverture du caisson est percé de trous correspondant à l'emplacement des goujons sur le cadre.

L'ensemble bouclier 28 et cadre 34 est introduit dans le caisson 2 par l'ouverture faite à cet effet dans la paroi latérale du caisson. Ensuite, les goujons 37 sont introduits dans des perçages 38 du contour de l'ouverture. Les goujons 37 font alors saillie à l'extérieur du caisson 2 (figure 6E).

Le boîtier peut par exemple être réalisé en polymère thermo-durci ou en tôle pliée.

Dans cet exemple, le boîtier 12 est muni de surfaces de fixation bordant toute son ouverture. Les surfaces de fixation sont munies de perçages pour le passage des goujons. Ces surfaces sont appliquées contre la face extérieure de la paroi latérale 4 du caisson 2 de sorte que les goujons 37 pénètrent dans les perçages des surfaces de fixation. Ensuite des systèmes d'écrou-contre écrou assurent la solidarisation.

Des moyens d'étanchéité sont prévus entre le boîtier 12 et le caisson 2, ces moyens sont en particulier étanches à la vapeur d'eau. Une étanchéité est également prévue au niveau des filetages à travers le caisson 2, par exemple utilisant des tubes étanches.

Le boîtier 12 peut être réalisé par emboutissage ou assemblé par soudage.

Dans une autre variante, des pions sont directement soudés sur la face intérieure de la paroi latérale sur laquelle est fixé le bouclier évitant d'utiliser un cadre tel que sur la figure 6B.

On peut également envisager de réaliser tout le dispositif préalablement et de le fixer sur le caisson. Par exemple, le boîtier serait muni d'une bride de fixation au caisson et des goujons seraient soudés sur la face extérieure du caisson pour la fixation de la bride. Des moyens d'étanchéité seraient interposés entre la bride et le caisson.

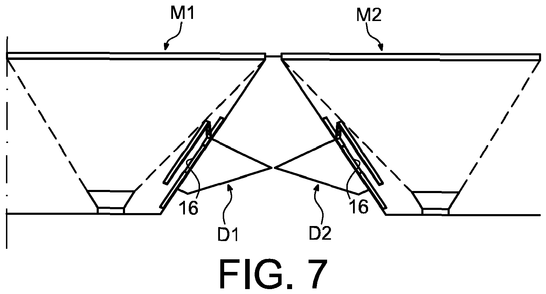

Sur la figure 7, on peut voir deux modules M1 et M2 disposés l'un à côté de l'autre et chacun équipé d'un dispositif de gestion d'humidité Dl, D2.

Dans l'exemple représenté, les deux dispositifs de gestion Dl, D2 sont sensiblement à la même hauteur. On pourrait prévoir qu'ils soient à deux hauteurs différentes.

En outre, de manière préférentielle, le dispositif de gestion est monté sur la partie basse du caisson de sorte que le bouclier ne soit pas éclairé par le flux solaire concentré, ce qui évite de réduire le flux vu par la cellule. En outre, le bouclier est également protégé. Le flux solaire est délimité par des traits interrompus.

Le fonctionnement du dispositif de gestion va maintenant être décrit à l'aide de la figure 1.

Sur la figure 1, les mouvements d'air par convection naturelle sont représentés par les flèches 38.

La représentation choisie est celle du moment de la fin de la nuit et début de matin, le moment où la température du fond supérieur 6 du caisson formé de lentilles est la plus froide et risque de descendre en dessous la température de rosée. Le refroidissement local qui s'opère au voisinage de la microstructure dentelée des lentilles de Fresnel au niveau de l'optique primaire provient des déperditions thermiques dues au rayonnement thermique vers le ciel pendant la nuit. De plus, la faible absorptivité et la forte transmittivité optiques des lentilles empêchent le flux solaire incident de réchauffer l'air localement.

En revanche, le fond inférieur 8 comportant les cellules photovoltaïques subit un réchauffement local dû à l'action des dissipateurs et de la tôle de fond qui sont soumis aux mouvements d'air locaux à température ambiante.

Il apparaît donc un gradient thermique dans le volume intérieur du module qui induit des transferts de masse d'air qui pilotent des mécanismes de convection d'air. De plus, l'air humide est plus léger que l'air sec.

Des écoulements d'air symbolisés par les flèches 38 ont donc lieu à proximité du boîtier contenant le matériau absorbant.

Il y a donc un écoulement d'air humide du bas vers le haut entre le bouclier 28 et la fenêtre 15 du boîtier 12. La vapeur d'eau contenue dans l'air est absorbée par le matériau absorbant à travers la membrane perméable. L'air qui ressort est alors asséché.

Le matériau absorbant, en absorbant la vapeur d'eau augmente de volume, l'enveloppe se déplie pour s'adapter au volume du matériau absorbant.

Dans le cas d'un matériau absorbant hygro-régulant, au cours de la journée lorsque la température dans le boîtier augmente suffisamment, le matériau se régénère en relarguant la vapeur d'eau dans le caisson et assure le maintien d'un niveau d'humidité sensiblement constant dans le caisson.

De manière préférentielle, on augmente l'absorptivité de la plaque bouclier, par exemple en la recouvrant de peinture noire, afin de générer une zone chaude et ainsi favoriser les écoulements d'air par convection à proximité du dispositif.

De préférence, le boîtier comporte des parois latérales triangulaires ou trapézoïdales ce qui permet d'augmenter la surface perméable à la vapeur d'eau. En effet la surface active est sensiblement égale à celle de la paroi de fond, dans les cas des figures 2A et 2C, sa surface est supérieure à celle d'un boîtier rectangulaire. En outre ces formes offrent un grand volume pour accommoder l'augmentation de volume du matériau absorbant.

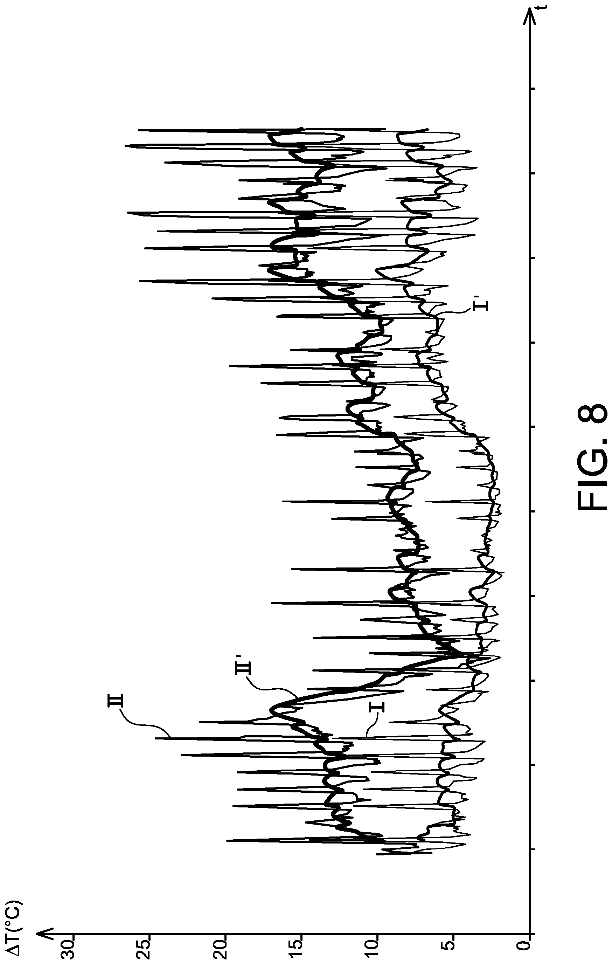

Sur la figure 8, on peut voir représenter par les courbes I et II la différence de température ΔT en °C en fonction du temps en jours entre l'air du caisson et la température de rosée de ce même air dans le cas d'un module sans dispositif de gestion selon l'invention et d'un module avec dispositif de gestion selon l'invention respectivement. Les courbes I' et II' représentent la moyenne mobile des courbes I et II respectivement.

Plus la différence de température est importante, plus le risque de voir apparaître de la condensation est réduit, sachant que la température de la lentille est au petit matin quelques degrés inférieure à celle de l'air du caisson, du fait du rayonnement de la lentille vers le ciel, par exemple de 2°C à 5°C par ciel clair. Ainsi au vu des différences de température représentées par la courbe II, si on considère une température de lentilles de 2 °C à 5°C, par rapport à celle de l'air du caisson, celle-ci reste encore très supérieure à la température de rosée.

On constate donc l'efficacité du dispositif de gestion selon l'invention.

A titre d'exemple, un sachet d'environ 1 kg de matériau absorbant et hygro-régulant a une durée de vie de l'ordre de 15 ans.

Le sachet peut être remplacé en démontant le boîtier par dévissage des écrous sur les goujons. Une trappe pourrait éventuellement être prévue dans le fond du boîtier pour faciliter le remplacement du sachet.

A titre d'exemple, le dispositif peut présenter les dimensions regroupées dans le tableau T1 ci-dessous en prenant pour référence :
H, la hauteur du caisson 2 du module M ;
L, la longueur du caisson 2 au niveau de son fond supérieur 6.
Les dimensions h, l a, b, e, f sont représentées sur la figure 2C.

**Tableau T1 : dimensions du dispositif de la figure 2C**

| **Dimension du boîtier** | |
|---|---|
| h | 0,1×H < h < 0,5×H |
| l | 0,1×L < h <0,9×L |
| a | 0,25×h < a < 1×h |
| b | 0 < b < 1×a |

| **Dimension du bouclier** | |
|---|---|
| e | 1×h < e < 2×h |
| f | 1×l < f < 2× |

| **Epaisseur des parois** | |
|---|---|
| Ep parois | 0,5 mm < Ep paroi< 2 mm |

| **Epaisseur de la lame d'air entre l'ouverture du boîtier et le bouclier** | |
|---|---|
| Ep lame d'air | 5 mm < Ep lame d'air < 50 mm |

Dans l'exemple représenté, le boîtier 12 du dispositif D est situé entièrement à l'extérieur du caisson 2. En variante, on peut envisager qu'une partie seulement du boîtier soit disposée à l'extérieur du caisson.

Le caisson peut également comporter un évent obturé par une membrane dite respirante, laissant passer l'air et la vapeur d'eau mais pas l'eau liquide.

En outre, un module peut comporter un ou plusieurs dispositifs de gestion d'humidité en fonction du volume d'air du module.

Le dispositif de gestion thermique présente de plus l'avantage de pouvoir être aisément monté sur des modules existants sans nécessité d'adaptation complexe.

Le dispositif de gestion d'humidité peut s'appliquer à tous les systèmes solaires à concentration.

## Revendications

1. Dispositif de gestion de l'humidité contenu dans un caisson (2) d'un module solaire (M), ledit dispositif comportant un boîtier (12) dont une des parois (14) est munie d'une fenêtre (15), au moins un matériau absorbant l'humidité disposé dans le boîtier (12), ledit dispositif étant destiné à être fixé sur une paroi latérale (4) du caisson (2) du module solaire (M) de sorte que ladite fenêtre (15) soit en regard d'une ouverture (16) réalisée dans ladite paroi latérale (4) assurant avec ladite fenêtre (15) une communication fluidique avec un volume intérieur d'un module solaire(M) charactérisé en ce que le dispositif comporte des moyens occultants (28) disposés en regard de la fenêtre (15) et à distance de celle-ci de sorte à ménager un espace pour l'écoulement d'air entre la fenêtre (15) et les moyens occultants (28), lesdits moyens occultants (28) étant aptes à protéger le matériau absorbant du rayonnement solaire concentré et destinés à être situés à l'intérieur du module solaire (M).

2. Dispositif de gestion de l'humidité selon la revendication 1, dans lequel le boîtier (12) comporte deux parois latérales (18, 118) de part et d'autre de la fenêtre (15) de forme triangulaire ou trapézoïdale orientées de sorte que la profondeur du boîtier (12) soit la plus grande dans sa partie supérieure.

3. Dispositif de gestion de l'humidité selon la revendication 1 ou 2, dans lequel les moyens occultants (28) comportent une plaque maintenue à distance de la fenêtre (15).

4. Dispositif de gestion de l'humidité selon l'une des revendications 1 à 3, comportant des moyens de protection supplémentaires (30, 130, 230, 330, 430) entre les moyens occultants (28) et le boitier (12).

5. Dispositif de gestion de l'humidité selon les revendications 3 et 4, dans lequel les moyens de protection supplémentaires (30, 130, 230, 330, 430) sont situés au niveau d'un bord supérieur de la plaque et sont portés par la plaque et/ou le boîtier (12), les moyens de protection supplémentaires (130) étant avantageusement ajourés.

6. Dispositif de gestion de l'humidité selon l'une des revendications 1 à 5, dans lequel le matériau absorbant est contenu dans un sachet souple (32), ledit sachet (32) étant avantageusement apte à s'adapter à une augmentation de volume du matériau absorbant.

7. Dispositif de gestion de l'humidité selon la revendication 6, dans lequel le sachet (32) comporte une face imperméable à la vapeur d'eau et une surface perméable à la vapeur d'eau, ladite face perméable étant en regard de la fenêtre.

8. Dispositif de gestion de l'humidité selon l'une des revendications 1 à 7, dans lequel le matériau absorbant est hygro-régulant, le matériau absorbant étant avantageusement du CaCl₂ sous forme de bille de 1 mm à 4 mm de diamètre.

9. Dispositif de gestion de l'humidité selon l'une des revendications 1 à 8, dans lequel le boîtier comporte des moyens de retenue (22, 122, 222, 322) dudit matériau dans le boîtier (12) de sorte à éviter qu'il sorte du boîtier (12).

10. Dispositif de gestion de l'humidité selon la revendication 9, dans lequel lesdits moyens de retenue (22, 122, 222, 322) sont formés par des traverses situées au niveau de zones supérieure et inférieure de la fenêtre (15) ou par des barreaux s'étendant au travers de la fenêtre (15).

11. Module solaire pour système solaire à concentration comportant un caisson (2) dont un fond supérieur (6) est formé par un système optique et un fond inférieur (8) opposé au fond supérieur (6) par au moins une cellule photovoltaïque (10) et une paroi latérale (4), et au moins un dispositif de gestion de l'humidité selon l'une des revendications 1 à 10, monté dans la paroi latérale (4) de manière étanche de sorte à obturer une ouverture (16) pratiquée dans la paroi latérale (4), la fenêtre (15) étant en regard de l'ouverture (16) et de sorte que les moyens occultants (28) soient disposés à l'intérieur du caisson (2).

12. Module solaire selon la revendication 11, dans lequel le dispositif de gestion d'humidité est situé en position basse du module de telle sorte que les moyens occultants (28) ne soient pas éclairés par le rayonnement solaire concentré lorsque le système solaire à concentration est correctement focalisé.

13. Module solaire selon la revendication 11 ou 12, dans lequel le caisson (2) comporte un évent obturé par une membrane respirante.

14. Module solaire selon la revendication 11 à 13, dans lequel les moyens occultants (28) sont fixés sur la face intérieure de la paroi latérale (4) et le boîtier (12) est fixé sur la face extérieure de la paroi latérale (4) du caisson (2).

15. Système solaire à concentration, avantageusement de type Fresnel, comportant un ou plusieurs modules solaires selon l'une des revendications 11 à 14.

## Patentansprüche

1. Vorrichtung zur Feuchtigkeitsregulierung, die in einem Kasten (2) eines Solarmoduls (M) enthalten ist, wobei die Vorrichtung ein Gehäuse (12), von dem eine der Wände (14) mit einem Fenster (15) versehen ist, und zumindest ein feuchtigkeitsabsorbierendes Material enthält, das in dem Gehäuse (12) angeordnet ist, wobei die Vorrichtung dazu bestimmt ist, an eine Seitenwand (4) des Kastens (2) des Solarmoduls (M) so befestigt zu werden, dass das Fenster (15) einer in der Seitenwand (4) ausgeführten Öffnung (16) gegenüberliegt und mit dem Fenster (15) eine fluidische Verbindung mit einem Innenraum eines Solarmoduls (M) sicherstellt, **dadurch gekennzeichnet, dass** die Vorrichtung Abdeckmittel (28) aufweist, die dem Fenster (15) gegenüberliegend und in einem Abstand von diesem angeordnet sind, so dass ein Zwischenraum für die Luftströmung zwischen dem Fenster (15) und den Abdeckmitteln (28) geschaffen wird, wobei die Abdeckmittel (28) dazu geeignet sind, das absorbierende Material vor der konzentrierten Sonneneinstrahlung zu schützen, und dazu bestimmt sind, innerhalb des Solarmoduls (M) zu liegen.

2. Vorrichtung zur Feuchtigkeitsregulierung nach Anspruch 1, wobei das Gehäuse (12) zwei Seitenwände (18, 118) beiderseits des Fensters (15) enthält, die dreieckförmig oder trapezförmig ausgeführt sind und so ausgerichtet sind, dass die Tiefe des Gehäuses (12) in seinem oberen Abschnitt am größten ist.

3. Vorrichtung zur Feuchtigkeitsregulierung nach Anspruch 1 oder 2, wobei die Abdeckmittel (28) eine Platte enthalten, die auf Abstand von dem Fenster (15) gehalten wird.

4. Vorrichtung zur Feuchtigkeitsregulierung nach einem der Ansprüche 1 bis 3, enthaltend zusätzliche Schutzmittel (30, 130, 230, 330, 430) zwischen den Abdeckmitteln (28) und dem Gehäuse (12).

5. Vorrichtung zur Feuchtigkeitsregulierung nach den Ansprüchen 3 und 4, wobei die zusätzlichen Schutzmittel (30, 130, 230, 330, 430) sich im Bereich eines oberen Randes der Platte befinden und von der Platte und/oder dem Gehäuse (12) getragen werden, wobei die zusätzlichen Schutzmittel (130) vorteilhaft durchbrochen ausgeführt sind.

6. Vorrichtung zur Feuchtigkeitsregulierung nach einem der Ansprüche 1 bis 5, wobei das absorbierende Material in einem nachgiebigen Beutel (32) enthalten ist, wobei der Beutel (32) vorteilhaft dazu geeignet ist, sich einer Volumenvergrößerung des absorbierenden Materials anzupassen.

7. Vorrichtung zur Feuchtigkeitsregulierung nach Anspruch 6, wobei der Beutel (32) eine wasserdampfundurchlässige Seite und eine wasserdampfdurchlässige Fläche aufweist, wobei die durchlässige Seite dem Fenster gegenüberliegt.

8. Vorrichtung zur Feuchtigkeitsregulierung nach einem der Ansprüche 1 bis 7, wobei das absorbierende Material hygroregulierend ist, wobei das absorbierende Material vorteilhaft CaCl₂ in Form von Kugeln mit 1 mm bis 4 mm Durchmesser ist.

9. Vorrichtung zur Feuchtigkeitsregulierung nach einem der Ansprüche 1 bis 8, wobei das Gehäuse Haltemittel (22, 122, 222, 322) zum Halten des Materials in dem Gehäuse (12) enthält, so dass ein Austreten aus dem Gehäuse (12) unterbunden wird.

10. Vorrichtung zur Feuchtigkeitsregulierung nach Anspruch 9, wobei die Haltemittel (22, 122, 222, 322) aus Querstützen gebildet sind, die im Bereich des oberen und unteren Abschnitts des Fensters (15) liegen, oder aus Stäben bestehen, die sich durch das Fenster (15) erstrecken.

11. Solarmodul für ein konzentrierendes Solarsystem, enthaltend einen Kasten (2), von dem ein Oberboden (6) aus einem optischen System gebildet ist und ein dem Oberboden (6) entgegengesetzter Unterboden (8) aus zumindest einer Fotovoltaikzelle (10) und einer Seitenwand (4) gebildet ist, sowie zumindest eine Vorrichtung zur Feuchtigkeitsregulierung nach einem der Ansprüche 1 bis 10, die in dichter Weise in der Seitenwand (4) angebracht ist, so dass eine in der Seitenwand (4) ausgeführte Öffnung (16) verschlossen wird, wobei das Fenster (15) der Öffnung (16) gegenüberliegt, und so dass die Abdeckmittel (28) innerhalb des Kastens (2) angeordnet sind.

12. Solarmodul nach Anspruch 11, wobei die Vorrichtung zur Feuchtigkeitsregulierung in der unteren Position des Moduls liegt, so dass die Abdeckmittel (28) nicht von der konzentrierten Sonneneinstrahlung beleuchtet werden, wenn das konzentrierende Solarsystem ordnungsgemäß fokussiert wird.

13. Solarmodul nach Anspruch 11 oder 12, wobei der Kasten (2) eine von einer atmungsaktiven Membran verschlossene Belüftung aufweist.

14. Solarmodul nach Anspruch 11 bis 13, wobei die Abdeckmittel (28) an die Innenseite der Seitenwand (4) befestigt sind und das Gehäuse (12) an die Außenseite der Seitenwand (4) des Kastens (2) befestigt ist.

15. Konzentrierendes Solarsystem, vorteilhaft vom Fresnel-Typ, enthaltend ein oder mehrere Solarmodule nach einem der Ansprüche 11 bis 14.

## Claims

1. A device for managing the moisture contained in a casing (2) of a solar module (M), said device comprising a housing (12) one of the walls (14) of which is provided with a window (15), at least one moisture absorbing material provided in the housing (12), said device being configured to be attached to a side wall (4) of the casing (2) of the solar module (M) such that said window (15) faces an aperture (16) made in said side wall (4) ensuring with said window (15) a fluid communication with an internal volume of a solar module (M), **characterized in that** the device comprises shielding means (28) provided facing the window (15) and away therefrom so as to provide a space for the air flow between the window (15) and the shielding means (28), said shielding means (28) being able to protect the absorbing material from the concentrated solar radiation, and being intended to be located inside the solar module (M),

2. The moisture managing device according to claim 1, wherein the housing (12) comprises two side walls (18, 118) on either side of the window (15) having a triangular or trapezoidal shape oriented such that the depth of the housing (12) be greatest in its upper part.

3. The moisture managing device according to claim 1 or 2, wherein the shielding means (28) comprise a plate kept distant from the window (15).

4. The moisture managing device according to one of claims 1 to 3, comprising additional protecting means (30, 130, 230, 330, 430) between the shielding means (28) and the housing (12).

5. The moisture managing device according to claims 3 and 4, wherein the further protecting means (30, 130, 230, 330, 430) are located at an upper edge of the plate and are carried by the plate and/or the housing (12), the addition protecting means (130) being advantageously pierced.

6. The moisture managing device according to one of claims 1 to 5, wherein the absorbing material is contained in a flexible pouch (32), said pouch (32) being advantageously adaptable to an increase in volume of the absorbing material.

7. The moisture managing device according to claim 6, wherein the pouch (32) comprises a water vapour impermeable face and a water vapour permeable surface, said permeable face being facing the window.

8. The moisture managing device according to one of claims 1 to 7, wherein the absorbing material is hygro-adjusting, the absorbing material being advantageously CaCI2 in the form of a ball with 1 mm to 4 mm diameter.

9. The moisture managing device according to one of claims 1 to 8, wherein the housing comprises means (22, 122, 222, 322) for retaining said material in the housing (12) so as to avoid that it comes out of the housing (12).

10. The moisture managing device according to claim 9, wherein said retaining means (22, 122, 222, 322) are formed by cross members located at upper and lower zones of the window (15) or by bars extending through the window (15).

11. A solar module for a concentrating solar system comprising a casing (2) an upper bottom (6) of which is formed by an optical system and a lower bottom (8) opposite to the upper bottom (6) by at least one photovoltaic cell (10) and a side wall (4), and at least one moisture managing device according to one of claims 1 to 10, sealingly mounted in the side wall (4) so as to seal an aperture (16) provided in the side wall (4), the window (15) being facing the aperture (16) and such that the shielding means (28) are provided inside the casing (2).

12. The solar module according to claim 11, wherein the moisture managing device is located at a low position of the module such that the shielding means (28) are not lighted by the concentrated solar radiation when the concentrating solar system is properly focused.

13. The solar module according to claim 11 or 12, wherein the casing (2) comprises an air vent sealed by a breathable membrane.

14. The solar module according to claim 11 to 13, wherein the shielding means (28) are attached to the inner face of the side wall (4) and the housing (12) is attached to the external face of the side wall (4) of the casing (2).

15. A concentrating solar system advantageously of the Fresnel type, comprising one or several solar modules according to one of claims 11 to 14.
